# EUROPÄISCHE PATENTSCHRIFT

(11) **EP 3 788 388 B1**
(45) Veröffentlichungstag und Bekanntmachung des Hinweises auf die Patenterteilung: **02.08.2023**
(21) Anmeldenummer: 19729699.9
(22) Anmeldetag: 04.06.2019
(51) Int. Cl.: G01R 15/06

(54) **SENSOREINRICHTUNG UND VERFAHREN ZUR BESTIMMUNG EINER WECHSELSPANNUNG**
SENSOR DEVICE AND METHOD FOR DETERMINING AN ALTERNATING VOLTAGE
DISPOSITIF CAPTEUR ET PROCÉDÉ DE DÉTERMINATION D'UNE TENSION ALTERNATIVE

(30) Priorität: 28.06.2018 DE 102018210568
(43) Veröffentlichungstag der Anmeldung: 10.03.2021
(73) Patentinhaber: Siemens Mobility GmbH, 81739 München (DE)
(72) Erfinder: SCHULZE, Michael, 12557 Berlin (DE); VOGT, Olaf, 12555 Berlin (DE)
(74) Vertreter: Siemens Patent Attorneys
(86) Internationale Anmeldenummer: PCT/EP2019/064433
(87) Internationale Veröffentlichungsnummer: WO 2020/001933

(56) Entgegenhaltungen:
- EP-A1- 2 508 898
- EP-A1- 2 993 480
- DE-A1-102008 055 651

## Beschreibung

Die Erfindung betrifft eine Sensoreinrichtung und ein Verfahren zur Bestimmung einer Wechselspannung zwischen einem Leiter und einem Bezugspotential von einem Weichenantrieb.

Bei Antriebsmotoren kann eine Schwergängikeit ein Indiz für eine erhöhte Wahrscheinlichkeit eines bald auftretenden Schadens und für die Notwendigkeit einer Wartung sein. Dies wird beispielsweise bei Weichenantrieben in eisenbahntechnischen Anlagen ausgenutzt, um eine Diagnose über den Zustand der Weichenantriebe anzustellen und Wartungen einzuplanen. Bei Weichenantrieben, die üblicherweise mit Wechselstrom über eine Vierdrahtschaltung betrieben werden, wird eine Wirkleistung bestimmt, die für den Zustand des Weichenantriebs repräsentativ ist und sich beispielsweise bei einer auftretenden Schwergängigkeit verändert. Die Wirkleistung ergibt sich beispielsweise als Produkt von Strom und Spannung unter Berücksichtigung der Phasenverschiebung.

Aus der DE 10 2008 055651 A1 ist beispielsweise ein Weichendiagnosesystem bekannt, bei dem Strom und Spannung in der Antriebsverkabelung des Weichenantriebs ermittelt werden, um daraus die Wirkleistung zu bestimmen.

Für die Spannungsmessung wird gemäß der DE 10 2008 055651 A1 eine galvanische Verbindung mit einem zusätzlichen Abzweig vom spannungsführenden Leiter zu einer Messeinrichtung hergestellt, um die Wechselspannung zu bestimmen. Dabei muss ein erhöhter Aufwand betrieben werden, um die Installation herzustellen und eine Rückwirkungsfreiheit nachzuweisen.

Aus der EP 2 993 480 A1 ist ein weiterer Spannungssensor bekannt. Die EP 2 508 898 A1 beschreibt ein Überwachungsverfahren für Hochspannungsmessungen.

Es ist daher die Aufgabe der vorliegenden Erfindung, eine Sensoreinrichtung und ein Verfahren der eingangs genannten Art bereitzustellen, die gegenüber bekannten Einrichtungen und Verfahren bezüglich Installation und den Nachweis der Rückwirkungsfreiheit weniger aufwändig sind.

Erfindungsgemäß wird die Aufgabe durch eine Sensoreinrichtung nach Anspruch 1 gelöst, die ein Sensorelement, das zur kapazitiven Kopplung mit dem Leiter ausgebildet ist, ein Widerstandselement, das zur Verbindung mit dem Bezugspotential vorgesehen und mit dem Sensoreinrichtung in Reihe verschaltet ist, und eine Verarbeitungseinrichtung, die zur Ermittlung eines Spannungsfalls über dem Widerstandselement ausgebildet ist, umfasst.

Weiterhin wird die Aufgabe erfindungsgemäß durch das Verfahren nach Anspruch 12 gelöst, bei dem ein Sensorelement mit dem Leiter kapazitiv gekoppelt wird, bei dem ein Widerstandselement mit dem Bezugspotential und dem Sensorelement in Reihe verschaltet wird und bei dem ein Spannungsfall über dem Widerstandselement ermittelt wird.

Die erfindungsgemäße Lösung hat den Vorteil, dass keine galvanische Verbindung zu dem Leiter und kein zusätzlicher Abzweig am Leiter nötig ist, um die Wechselspannung zu bestimmen. Vielmehr ist die erfindungsgemäße Sensoreinrichtung galvanisch vom Leiter getrennt und der Leiter weist auch keinen zusätzlichen Abzweig auf, wodurch eine Rückwirkungsfreiheit gegeben und leicht nachweisbar ist.

Erfindungsgemäß wird ein kapazitiv-resistiver Spannungsteiler vorgesehen, der insbesondere bei den für Weichenantriebe üblichen Wechselspannungen von einigen einhundert Volt, z.B. 400 V, sowie Netzfrequenzen von 50 Hz oder 60 Hz positive Eigenschaften hat. Eine dieser Eigenschaften ist, dass ein Pegel des Spannungsfalls über dem Widerstandselement in einen messtechnisch sinnvoll auswertbaren Bereich fällt. Weiterhin kann von einer definierten reproduzierbaren Phasenverschiebung zwischen der zu bestimmenden Wechselspannung und der Spannung über dem Widerstandselement ausgegangen werden, so dass dieser nicht aufwendig bestimmt werden muss.

Um eine ausreichende Schirmung gegen elektrische Fremdfelder bzw. gegen parasitären Einfluss benachbarter Leiter zu gewährleisten, weist die erfindungsgemäße Sensoreinrichtung wenigstens ein mit dem Widerstandselement verbundenes Schirmungselement auf. Das Schirmungselement ist zur Verbindung mit dem Bezugspotential ausgebildet und so angeordnet, dass das Schirmungselement und das Sensorelement kapazitiv miteinander gekoppelt sind. Dabei können das Schirmungselement und das Sensorelement zumindest abschnittsweise koaxial zueinander angeordnet sein. Dadurch wird ein weiterer Zylinderkondensator ausgebildet, der durch seine Kompaktheit Vorteile bietet.

Die erfindungsgemäße Lösung kann durch vorteilhafte Ausgestaltungen weiterentwickelt werden, die im Folgenden beschrieben sind.

Das Sensorelement kann so ausgestaltet sein, dass es zum Leiter koaxial anordenbar ist. Dies hat den Vorteil, dass die Sensoreinrichtung dadurch sehr leicht an bestehenden Leitern, wie beispielsweise den Phasenleitern eines Weichenantriebs, angeordnet werden kann. Dadurch ist eine Nachrüstung bei bereits in Betrieb befindlichen Antrieben leicht möglich. Durch die koaxiale Anordnung wird ein Zylinderkondensator aus dem Leiter und der Sensoreinrichtung gebildet, der besonders kompakt und dadurch vorteilhaft ist.

Um bei der Spannungsermittlung verschiedene Einflussgrößen wie beispielsweise die Eingangsimpedanz einer modernen hochohmigen Verarbeitungseinrichtung oder ähnliches vernachlässigen zu können, kann das Widerstandselement einen Widerstand von zwischen 1 und 1000 kΩ aufweisen. Durch den relativ kleinen Widerstand des Widerstandselements werden die anderen Einflussgrößen vernachlässigbar und brauchen bei der Berechnung der Spannung nicht berücksichtigt zu werden.

In einer vorteilhaften Ausgestaltung kann die Sensoreinrichtung wenigstens einen Kondensator aufweisen, der parallel zu dem Widerstandselement angeordnet ist. Dies hat den Vorteil, dass durch den als konzentriertes Bauelement ausgeführten Kondensator ein Filter gegen hochfrequente Störungen in der Sensoreinrichtung integriert ist. Dabei kann der Kondensator eine Kapazität von beispielsweise wenigstens 1 nF aufweisen.

In einer weiteren vorteilhaften Ausgestaltung kann das Sensorelement so ausgebildet sein, dass es im gekoppelten Zustand mit dem Leiter einen Kondensator ausbildet, der eine Kapazität von höchstens 500 pF, vorzugsweise höchstens 100 pF, aufweist. Durch die Begrenzung der Kapazität kann von einem annähernd konstanten Phasenwinkel ausgegangen werden, so dass keine Einmessung des Phasenwinkels bei der erfindungsgemäßen Sensoreinrichtung erforderlich ist. Die vorteilhafte hinreichend kleine Kapazität zwischen Sensorelement und Leiter kann beispielsweise durch die konstruktive Ausgestaltung der Sensoreinrichtung beeinflusst werden. Dies kann beispielsweise durch die als Dielektrikum dienende Isolierung zwischen Leiter und Sensorelement oder auch durch die Breite der Sensoreinrichtung und insbesondere des Sensorelements bestimmt werden.

Die Verarbeitungseinrichtung kann zur Berechnung der Spannung zwischen Leiter und Bezugspotential ausgebildet sein. Dies hat den Vorteil, dass keine zusätzliche Verarbeitungseinrichtung zur Berechnung der Spannungen nötig ist.

Um eine sinnvoll auswertbare Spannung über dem Widerstandselement zu erreichen, kann die Sensoreinrichtung so ausgebildet sein, dass sie im Betrieb mit dem Leiter einen Kondensator mit einer Kapazität von wenigstens 3 pF ausbildet.

Die Erfindung betrifft ferner auch eine Weichendiagnoseeinrichtung mit einer ersten Sensoreinrichtung zur Bestimmung eines Stromes in einem Leiter eines Weichenantriebs, mit einer zweiten Sensoreinrichtung zur Bestimmung einer Wechselspannung zwischen dem wenigstens einem Phasenleiter und einem Nullleiter des Weichenantriebs als Bezugspotential ausgebildet ist und mit einer Auswerteeinrichtung, die aus den bestimmten Strom- und Spannungswerten eine repräsentative Wirkleistung des Weichenantriebs bestimmt. Um einen Installationsaufwand und einen Nachweis von Rückwirkungsfreiheit zu vereinfachen, ist erfindungsgemäß vorgesehen, dass die zweite Sensoreinrichtung nach einer der zuvor genannten Ausführungsformen ausgebildet ist.

Die Erfindung betrifft außerdem einen Weichenantrieb mit wenigstens einem Phasen-Leiter zur Stromversorgung des Weichenantriebs, mit wenigsten einem Null-Leiter und mit wenigstens einer Sensoreinrichtung zur Bestimmung einer Wechselspannung zwischen dem wenigstens einem Phasenleiter und dem Nullleiter als Bezugspotential. Um einen Installationsaufwand und die Nachweisbarkeit einer Rückwirkungsfreiheit zu verringern, ist es erfindungsgemäß vorgesehen, dass die Sensoreinrichtung nach einer der zuvor genannten Ausführungsformen ausgebildet ist.

Schließlich betrifft die Erfindung noch ein Verfahren zur Weichendiagnose, bei dem eine Wechselspannung zwischen einem Phasenleiter und einem Null-Leiter eines Weichenantriebs als Bezugspotential und ein Wechselstrom in dem Phasenleiter bestimmt werden und bei dem eine Wirkleistung des Weichenantriebs mittels der Wechselspannung und dem Wechselstrom bestimmt wird und bei dem anhand der Wirkleistung ein Zustand des Weichenantriebs diagnostiziert wird. Um einen Installationsaufwand und die Nachweisbarkeit einer Rückwirkungsfreiheit zu vereinfachen, ist es erfindungsgemäß vorgesehen, dass die Wechselspannung nach dem zuvor genannten erfindungsgemäßen Verfahren bestimmt wird.

Im Folgenden wird die Erfindung mit Bezug auf die beigefügten Zeichnungen erläutert.
- Figur 1: eine schematische Darstellung eines erfindungsgemäßen Weichenantriebs mit einer erfindungsgemäßen Sensoreinrichtung;
- Figur 2: eine schematische Darstellung der beispielhaften Ausführungsform einer erfindungsgemäßen Sensoreinrichtung aus Figur 1;
- Figuren 3 und 4: schematische Darstellungen der beispielhaften Ausführungsform der erfindungsgemäßen Sensoreinrichtung aus Figur 2 in verschiedenen Ansichten;
- Figur 5: eine schematische Darstellung eines Schaltbildes der erfindungsgemäßen Sensoreinrichtung nach Figuren 2 -4;
- Figur 6: eine schematische Prinzipdarstellung einer weiteren Ausführungsform einer erfindungsgemäßen Sensoreinrichtung.

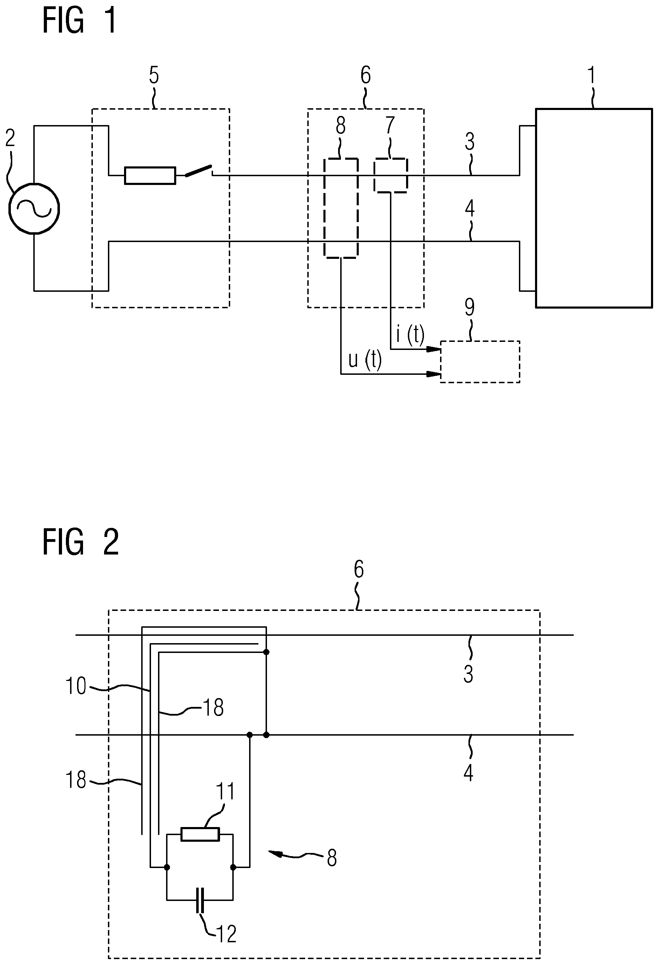

Figur 1 zeigt einen erfindungsgemäßen Weichenantrieb 1, der mit einer Wechselspannungsquelle 2 verbunden ist.

Dabei ist ein Phasenleiter 3 mit einer Phase der Wechselspannungsquelle 2 und ein Null-Leiter 4 mit einem Null-Leiter der Wechselspannungsquelle 2 verbunden.

Gegebenenfalls kann ein Trennerstromkreis 5 zwischen Wechselspannungsquelle 2 und Weichenantrieb 1 angeordnet sein, der gegebenenfalls einen veränderlichen Vorwiderstand aufweisen kann.

Weiterhin ist zwischen der Wechselspannungsquelle 2 und dem Weichenantrieb 1 eine Weichendiagnoseeinrichtung 6 vorgesehen. Die Weichendiagnoseeinrichtung 6 umfasst eine erste Sensoreinrichtung 7 zur Bestimmung eines Stromes in dem Phasenleiter 3 und eine zweite Sensoreinrichtung 8 zur Bestimmung einer Wechselspannung zwischen dem Phasenleiter 3 und dem Null-Leiter 4. Die Weichendiagnoseeinrichtung 6 weist außerdem eine Auswerteeinrichtung 9 auf, die aus den ermittelten Strom- und Spannungswerten eine repräsentative Wirkleistung des Weichenantriebs 1 bestimmen kann. Die Wirkleistung ist für den Zustand des Weichenantriebs 1 repräsentativ und wird zur Diagnose genutzt.

Figur 2 zeigt die Weichendiagnoseeinrichtung 6 aus Figur 1 im Detail, wobei der Einfachheit halber lediglich die erfindungsgemäße zweite Sensoreinrichtung 8 dargestellt ist.

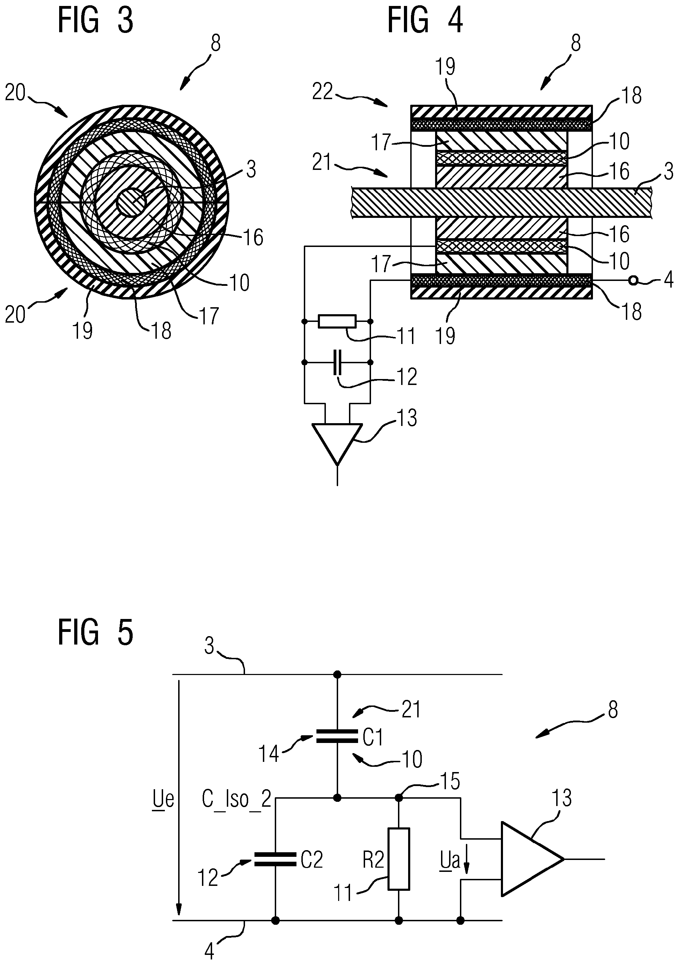

Zunächst wird der Aufbau der erfindungsgemäßen Sensoreinrichtung 8 anhand des schematischen Ersatzschaltbildes in Figur 5 beschrieben.

Die Sensoreinrichtung 8 ist mit dem Phasenleiter 3 und dem Null-Leiter 4 des Weichenantriebs 2 (in Figur 5 nicht dargestellt) gekoppelt. Die Sensoreinrichtung umfasst in der beispielhaften Ausführungsform in Figur 5 ein Sensorelement 10, ein Widerstandselement 11, einen Kondensator 12 und eine Verarbeitungseinrichtung 13.

Das Sensorelement 10 ist elektrisch leitend und zur kapazitiven Kopplung mit dem Phasenleiter 3 ausgebildet. Zusammen mit dem Phasenleiter 3 bildet das Sensorelement 10 im Betrieb der Sensoreinrichtung 8 einen Kondensator 14 aus.

Das Widerstandselement 11 ist beispielsweise als ein ohmscher Widerstand ausgebildet und im Betrieb der Sensoreinrichtung 8 mit dem Null-Leiter 4 als Bezugspotential galvanisch verbunden. Das Widerstandselement 11 ist mit dem Sensorelement 10 in Reihe verschaltet und weist bei der beispielhaften Ausführungsform in den Figuren beispielsweise einen Widerstand von 100 kΩ auf. Hier kann natürlich auch ein anderer Widerstand verwendet werden, vorzugsweise zwischen 1 und 1000 kOhm.

Der Kondensator 12 ist parallel zum Widerstandselement 11 verschaltet und weist bei der beispielhaften Ausführungsform in den Figuren eine Kapazität von 1 nF auf.

Die Verarbeitungseinrichtung 13 ist zur Ermittlung eines Spannungsfalls Ua über dem Widerstandselement 11 ausgebildet. Diese Spannung Ua wird beispielsweise wie in Figur 5 dargestellt zwischen dem Null-Leiter 4 und einem Knotenpunkt 15 zwischen dem Widerstandselement 11 und dem Sensorelement 10 ausgekoppelt.

Wie in Figur 5 dargestellt bildet die erfindungsgemäße Sensoreinrichtung zwischen dem Phasenleiter 3 und dem Null-Leiter 4 einen kapazitiv-resistiven Spannungsteiler aus.

Im Folgenden wird anhand der Figuren 3 und 4 die vorteilhafte erfindungsgemäße Ausgestaltung der erfindungsgemäßen Sensoreinrichtung 8 beschrieben. Figur 3 zeigt die Anordnung im Querschnitte, Figur 4 in einem Längsschnitt.

Die Sensoreinrichtung 8 ist dabei zumindest abschnittsweise koaxial zum Phasenleiter 3 angeordnet. Der Phasenleiter 3 und dessen umgebende Isolierung 16 werden für die Ermittlung der Spannung innerhalb der Sensoreinrichtung 8 angeordnet. Koaxial um den Phasenleiter 3 und dessen Isolierung 16 ist dabei das Sensorelement 10 angeordnet. Das Sensorelement 10 und der Phasenleiter 3 bilden zusammen einen Zylinderkondensator, bei dem die Isolierung 16 als Dielektrikum dient. Das Sensorelement 10 ist nach außen wiederum von einer weiteren Isolierung 17 umgeben. Um diese Isolierung 17 wiederum ist ein leitendes Schirmungselement 18 angeordnet, das ebenfalls koaxial zum Phasenleiter 3 ausbildet ist und dadurch mit dem Sensorelement 10 einen weiteren Zylinderkondensator ausbildet. Die Sensoreinrichtung 8 ist nach außen um das Schirmungselement 18 herum mit einer Außenisolierung 19 versehen. Alternativ wäre eine Sensoreinrichtung auch ohne Schirmungselement 18 denkbar.

Zur einfacheren Handhabung kann die erfindungsgemäße Sensoreinrichtung 8 geteilt ausgebildet sein und dadurch z.B. zwei Hälften 20 aufweisen. Durch diese Teilbarkeit kann die Sensoreinrichtung 8 besonders einfach um den Phasenleiter 3 angeordnet werden. Das Schirmungselement 18 ist mit dem Null-Leiter 4 als Bezugspotential verbunden. Wie bereits mit Bezug auf Figur 5 beschrieben, ist zwischen dem Sensorelement 10 und dem Schirmungselement 18 das Widerstandselement 11 und parallel dazu der Kondensator 12 verschaltet. Die Verarbeitungseinrichtung 13 ermittelt wiederum den Spannungsfall über dem Widerstandselement 11.

Wie in Figur 2 gezeigt ist das Schirmungselement 18 bis zum Abzweig von Widerstandselement 11 und Kondensator 12 geführt, um eine gute Schirmung zu gewährleisten. Die Verarbeitungseinrichtung 13 ist in Figur 2 zwar nicht dargestellt, aber trotzdem vorhanden und gehört zur dargestellten Ausführungsform.

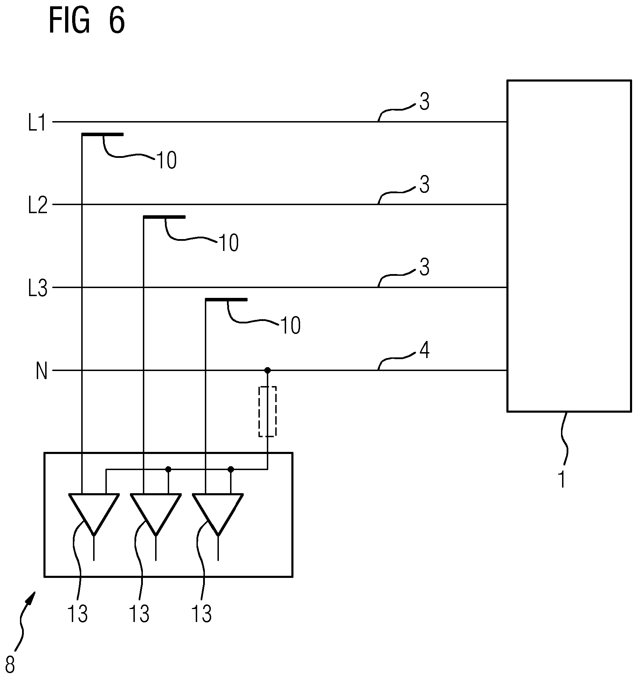

Figur 6 zeigt eine alternative Ausführungsform der erfindungsgemäßen Sensoreinrichtung, die im Vergleich zu der zuvor beschriebenen Ausführungsform die Wechselspannung in drei Phasenleitern 3 misst. Dafür ist die Sensoreinrichtung 8 in Figur 6 mit drei Sensorelementen 10 ausgebildet, die jeweils kapazitiv mit einem der Phasenleiter 3 gekoppelt sind. Die Ermittlung der Wechselspannung in jedem Phasenleiter 3 entspricht aber der der zuvor beschriebenen Ausführungsform der Figuren 1 bis 5.

Die erfindungsgemäße Sensoreinrichtung 8 weist allgemein und unabhängig von den Ausführungsformen den Vorteil auf, dass der Phasenleiter 3 und dessen Isolierung 16 in ihrer bereits vorhandenen Form verwendet werden können, ohne selbst verändert oder kontaktiert werden zu müssen. Dadurch eignet sich die erfindungsgemäße Sensoreinrichtung 8 besonders auch zum Nachrüsten für bestehende Weichenantriebe 1. In der erfindungsgemäßen Sensoreinrichtung 8 entsteht nachdem sie am Phasenleiter 3 angeordnet ist, der erste Zylinderkondensator 21 mit einer Kapazität C1 aus dem Sensorelement 10 und dem Phasenleiter 3 sowie ein zweiter Zylinderkondensator 22 C_iso_2 zwischen dem Sensorelement 10 und dem Schirmungselement 18.

In der erfindungsgemäßen Sensoreinrichtung 8 wird ein kapazitiv-resistiver Spannungsteiler ausgebildet, der durch die erfindungsgemäße Dimensionierung und den Betrieb bei Wechselspannungen von einigen einhundert Volt, so wie bei Weichenantrieben 1 üblich, sowie bei einer Netzfrequenz von beispielsweise 50 Hz oder 60 Hz folgende Eigenschaften hat:
Der Pegel der abgegriffenen Spannung Ua liegt in einem messtechnisch sinnvoll auswertbaren Bereich.

Es trifft eine definierte reproduzierbare Phasenverschiebung zwischen der zu messenden Spannung Ue und der Spannung am Widerstandselement 11 Ua zu.

Es findet eine ausreichende Schirmung durch das Schirmungselement 18 gegen elektrische Fremdfelder oder auch gegen parasitären Einfluss benachbarter Leiter statt.

Dabei ist es von Vorteil, wenn folgende Randbedingungen eingehalten werden:
Der Kondensator 14 wird so ausgestaltet, dass er eine Kapazität von > 3 pF aufweist. Dadurch kann eine mit einfachen Mitteln auswertbare Spannung Ua erreicht werden. Es kann angenommen werden, dass Leitungswiderstände und
Leiterinduktivitäten bei den betrachteten Frequenzen unterhalb von 1 kHz und der Größe des Sensorelements 10 vernachlässigbar klein sind. Das Sensorelement 10 kann z.B. etwa 40 mm breit sein. Ferner kann angenommen werden, dass Isolationswiderstände der als Dielektrika dienenden Isolierungen 16 und 17 derart hoch sind, dass sie in der Impedanzberechnung nicht berücksichtigt werden müssen. Um die Isolierung 16 kann gegebenenfalls auch noch eine weitere Schutzisolierung (nicht dargestellt) verwendet werden.

In der beispielhaften Ausführungsform der Figuren 1 bis 5 ist die Kapazität C2 des zusätzlichen Kondensators 12 mit 1 nF und der Widerstand des Widerstandselements 11 mit 100 kΩ so gewählt, dass dadurch sowohl die Kapazität C_iso_2 wie auch die Eingangsimpedanz der Verarbeitungseinrichtung 13 vernachlässigt werden können. Wie oben bereits erwähnt dient der zusätzliche Kondensator 12 weiterhin als Filter gegen hochfrequente Störungen.

Für eine anzunehmende Größenordnung der Kapazität von C1 von einigen pF ergeben sich für Nutzfrequenzen von 50 Hz bzw. 60 Hz Dämpfungsfaktoren in der Größenordnung von etwa 1:5000 und Phasenwinkel zwischen der zu messenden Spannung Ue und der gemessenen Spannung Ua nahe - 90°. Da der Widerstand des Widerstandselements 11 und die Kapazität des Kondensators 12 bekannt sind, hängt der Dämpfungsfaktor im Wesentlichen von der Kapazität C1 ab und könnte durch Einmessen bestimmt werden. Da der Phasenwinkel aber bei den genannten Frequenzen und einem hinreichend kleinem Kapazität C1 von wesentlich < 500 pF stets zwischen - 87° und -89° erwartet werden kann, kann auf dessen Einmessung verzichtet werden. Dies ist vorteilhaft.

## Patentansprüche

1. Sensoreinrichtung (8) zur Bestimmung einer Wechselspannung (Ue) zwischen einem Leiter (3) und einem Bezugspotential (4) von einem Weichenantrieb (1),
mit einem Sensorelement (10), das zur kapazitiven Koppelung mit dem Leiter (3) ausgebildet ist,
mit einem Widerstandselement (11), das zur Verbindung mit dem Bezugspotential (4) vorgesehen und mit dem Sensorelement (10) in Reihe verschaltet ist,
und mit einer Verarbeitungseinrichtung (13), die zur Ermittlung eines Spannungsfalls (Ua) über dem Widerstandselement (11) ausgebildet ist
**dadurch gekennzeichnet, dass**
die Sensoreinrichtung (8) wenigstens ein mit dem Widerstandselement (11) verbundenes Schirmungselement (18) aufweist, das zur Verbindung mit dem Bezugspotential (4) ausgebildet ist und so angeordnet ist, dass das Schirmungselement (18) und das Sensorelement (10) kapazitiv miteinander gekoppelt sind.

2. Sensoreinrichtung (8) nach Anspruch 1,
**dadurch gekennzeichnet, dass**
das Sensorelement (10) so ausgestaltet ist, dass es zum Leiter (3) koaxial anordenbar ist.

3. Sensoreinrichtung (8) nach Anspruch 1 oder 2,
**dadurch gekennzeichnet, dass**
das Widerstandselement (11) einen Widerstand zwischen 1 und 1000 kOhm aufweist.

4. Sensoreinrichtung (8) nach einem der oben genannten Ansprüche,
**dadurch gekennzeichnet, dass**
die Sensoreinrichtung (8) wenigstens einen Kondensator (12) aufweist, der parallel zu dem Widerstandselement (11) angeordnet ist.

5. Sensoreinrichtung (8) nach Anspruch 4,
**dadurch gekennzeichnet, dass**
der Kondensator (12) eine Kapazität von wenigstens 1 nF aufweist.

6. Sensoreinrichtung (8) nach einem der oben genannten Ansprüche,
**dadurch gekennzeichnet, dass**
das Schirmungselement (18) und das Sensorelement (10) zumindest abschnittsweise koaxial zueinander angeordnet sind.

7. Sensoreinrichtung (8) nach einem der oben genannten Ansprüche,
**dadurch gekennzeichnet, dass**
das Sensorelement (10) so ausgebildet ist, dass es im gekoppelten Zustand mit dem Leiter (3) einen Kondensator (14, 21) ausbildet, der eine Kapazität von höchstens 500 pF, vorzugsweise höchstens 100 pF, aufweist.

8. Sensoreinrichtung (8) nach einem der oben genannten Ansprüche,
**dadurch gekennzeichnet, dass**
die Verarbeitungseinrichtung (13) zur Berechnung der Spannung zwischen Leiter (3) und Bezugspotential (4) ausgebildet ist.

9. Sensoreinrichtung (10) nach einem der oben genannten Ansprüche,
**dadurch gekennzeichnet, dass**
die Sensoreinrichtung (8) so ausgestaltet ist, dass sie im Betrieb mit dem Leiter (3) einen Kondensator (14, 21) mit einer Kapazität von wenigstens 3 pF ausbildet.

10. Weichendiagnoseeinrichtung (6),
mit einer ersten Sensoreinrichtung (7) zur Bestimmung eines Stromes in wenigstens einem Phasen-Leiter (3) eines Weichenantriebs (1),
mit einer zweiten Sensoreinrichtung (8) zur Bestimmung einer Wechselspannung zwischen dem wenigstens einem Phasen-Leiter (3) und einem Null-Leiter (4) des Weichenantriebs (1) ausgebildet ist und
mit einer Auswerteeinrichtung (9), die aus den bestimmten Strom- und Spannungswerten eine repräsentative Wirkleistung des Weichenantriebs (1) bestimmt,
**dadurch gekennzeichnet, dass**
das die zweite Sensoreinrichtung (8) nach einem der oben genannten Ansprüche ausgebildet ist.

11. Weichenantrieb (1)
mit wenigstens einem Phasen-Leiter (3) zur Stromversorgung,
mit wenigstens einem Null-Leiter (4) und
mit wenigstens einer Sensoreinrichtung (8) zur Bestimmung einer Wechselspannung zwischen dem wenigstens einen Phasen-Leiter (3) und dem Null-Leiter (4),
**dadurch gekennzeichnet, dass**
die Sensoreinrichtung (8) nach einem der oben genannten Ansprüche 1 bis 9 ausgebildet ist.

12. Verfahren zur Bestimmung einer Wechselspannung (Ue) zwischen einem Leiter (3) und einem Bezugspotential (4) von einem Weichenantrieb,
bei dem ein Sensorelement (10) mit dem Leiter (3) kapazitiv gekoppelt wird,
bei dem ein Widerstandselement (11) mit dem Bezugspotential (4) und dem Sensorelement (10) in Reihe verschaltet wird und bei dem ein Spannungsfall (Ua) über dem Widerstandselement (11) ermittelt wird,
**dadurch gekennzeichnet dass**
die Sensoreinrichtung (8) wenigstens ein mit dem Widerstandselement (11) verbundenes Schirmungselement (18) aufweist, das zur Verbindung mit dem Bezugspotential (4) ausgebildet ist und so angeordnet ist, dass das Schirmungselement (18) und das Sensorelement (10) kapazitiv miteinander gekoppelt sind.

13. Verfahren zur Weichendiagnose,
bei dem eine Wechselspannung (Ue) zwischen einem Phasen-Leiter (3) und einem Null-Leiter (4) eines Weichenantriebs (1) und ein Wechselstrom in dem Phasen-Leiter (3) bestimmt werden,
bei dem eine Wirkleistung des Weichenantriebs (1) mittels der Wechselspannung und dem Wechselstrom bestimmt wird und
bei dem anhand der Wirkleistung ein Zustand des Weichenantriebs diagnostiziert wird,
**dadurch gekennzeichnet, dass**
die Wechselspannung (Ue) nach dem Verfahren nach Anspruch 12 bestimmt wird.

## Claims

1. Sensor device (8) for determining an alternating voltage (Ue) between a conductor (3) and a reference potential (4) of a points drive (1),
with a sensor element (10), which is embodied for capacitively coupling to the conductor (3),
with a resistor element (11), which is provided for connecting to the reference potential (4) and is interconnected in series with the sensor element (10),
and with a processing device (13), which is embodied for ascertaining a voltage drop (Ua) across the resistor element (11),
**characterised in that**
the sensor device (8) has at least one shielding element (18) connected to the resistor element (11), which is embodied for connecting to the reference potential (4) and is arranged such that the shielding element (18) and the sensor element (10) are capacitively coupled to one another.

2. Sensor device (8) according to claim 1,
**characterised in that**
the sensor element (10) is configured such that it can be arranged coaxially with the conductor (3).

3. Sensor device (8) according to claim 1 or 2,
**characterised in that**
the resistor element (11) has a resistance between 1 and 1000 kiloohms.

4. Sensor device (8) according to one of the claims mentioned above,
**characterised in that**
the sensor device (8) has at least one capacitor (12), which is arranged in parallel with the resistor element (11).

5. Sensor device (8) according to claim 4,
**characterised in that**
the capacitor (12) has a capacitance of at least 1 nF.

6. Sensor device (8) according to one of the claims mentioned above,
**characterised in that**
the shielding element (18) and the sensor element (10) are arranged coaxially with one another, at least in sections.

7. Sensor device (8) according to one of the claims mentioned above,
**characterised in that**
the sensor element (10) is embodied such that, in the state in which it is coupled to the conductor (3), it embodies a capacitor (14, 21) which has a capacitance of at most 500 pF, preferably at most 100 pF.

8. Sensor device (8) according to one of the claims mentioned above,
**characterised in that**
the processing device (13) is embodied for calculating the voltage between conductor (3) and reference potential (4).

9. Sensor device (10) according to one of the claims mentioned above,
**characterised in that**
the sensor device (8) is embodied such that during operation it embodies a capacitor (14, 21) with a capacitance of at least 3 pF with the conductor (3).

10. Points diagnostics device (6),
with a first sensor device (7) for determining a current in at least one phase conductor (3) of a points drive (1),
with a second sensor device (8) for determining an alternating voltage between the at least one phase conductor (3) and a neutral conductor (4) of the points drive (1) and
with an evaluation device (9), which determines a representative active power of the points drive (1) from the determined current and voltage values.
**characterised in that**
the second sensor device (8) is embodied according to one of the claims mentioned above.

11. Points drive (1)
with at least one phase conductor (3) for supplying current,
with at least one neutral conductor (4) and
with at least one sensor device (8) for determining an alternating voltage between the at least one phase conductor (3) and the neutral conductor (4),
**characterised in that**
the sensor device (8) is embodied according to one of claims 1 to 9 mentioned above.

12. Method for determining an alternating voltage (Ue) between a conductor (3) and a reference potential (4) of a points drive,
in which a sensor element (10) is capacitively coupled to the conductor (3),
in which a resistor element (11) is interconnected in series with the reference potential (4) and the sensor element (10) and in which a voltage drop (Ua) across the resistor element (11) is ascertained,
**characterised in that**
the sensor device (8) has at least one shielding element (18) connected to the resistor element (11), which is embodied for connecting to the reference potential (4) and is arranged such that the shielding element (18) and the sensor element (10) are capacitively coupled to one another.

13. Method for points diagnostics,
in which an alternating voltage (Ue) between a phase conductor (3) and a neutral conductor (4) of a points drive (1) and an alternating current in the phase conductor (3) are determined, in which an active power of the points drive (1) is determined by means of the alternating voltage and the alternating current and
in which a status of the points drive is diagnosed on the basis of the active power,
**characterised in that**
the alternating voltage (Ue) is determined according to the method according to claim 12.

## Revendications

1. Dispositif (8) capteur de détermination d'une tension (Ue) alternative entre un conducteur (3) et un potentiel (4) de référence d'un mécanisme (1) de commande d'aiguille,
comprenant un élément (10) de capteur, qui est constitué pour se coupler capacitivement avec le conducteur (3),
comprenant un élément (11) de résistance, qui est prévu pour la liaison avec le potentiel (4) de référence et qui est monté en série avec l'élément (10) de capteur,
et comprenant un dispositif (13) de traitement, qui est constitué pour la détermination d'une chute (Ua) de tension aux bornes de l'élément (11) de résistance,
**caractérisé en ce que**
le dispositif (8) capteur a au moins un élément (18) de blindage, qui est relié à l'élément (11) de résistance et qui est constitué et disposé pour la liaison avec le potentiel (4) de référence, de manière à ce que l'élément (18) de blindage et l'élément (10) soient couplés entre eux capacitivement.

2. Dispositif (8) capteur suivant la revendication 1,
**caractérisé en ce que**
l'élément (10) de capteur est conformé de manière à pouvoir être disposé coaxialement au conducteur (3).

3. Dispositif (8) capteur suivant la revendication 1 ou 2,
**caractérisé en ce que**
l'élément (11) de résistance a une résistance comprise entre 1 et 1000 kOhm.

4. Dispositif (8) capteur suivant l'une des revendications précédentes,
**caractérisé en ce que**
le dispositif (8) capteur a au moins un condensateur (12), qui est monté en parallèle avec l'élément (11) de résistance.

5. Dispositif (8) capteur suivant la revendication 4,
**caractérisé en ce que**
le condensateur (12) a une capacité d'au moins 1 nF.

6. Dispositif (8) capteur suivant l'une des revendications précédentes,
**caractérisé en ce que**
l'élément (18) de blindage et l'élément (10) de capteur sont disposés au moins par endroits coaxialement l'un à l'autre.

7. Dispositif (8) capteur suivant l'une des revendications précédentes,
**caractérisé en ce que**
l'élément (10) de capteur est constitué de manière à former, à l'état couplé avec le conducteur (3), un condensateur (14, 21), qui a une capacité de 500 pF au plus, de préférence de 100 pF au plus.

8. Dispositif (8) capteur suivant l'une des revendications précédentes,
**caractérisé en ce que**
le dispositif (13) de traitement est constitué pour le calcul de la tension entre le conducteur (3) et le potentiel (4) de référence.

9. Dispositif (10) capteur suivant l'une des revendications précédentes,
**caractérisé en ce que**
le dispositif (8) capteur est conformé de manière à constituer en fonctionnement avec le conducteur (3) un condensateur (14, 21) d'une capacité d'au moins d'au moins 3 pF.

10. Dispositif (6) de diagnostic d'aiguille,
comprenant un premier dispositif (7) capteur de détermination d'un courant dans au moins un conducteur (3) de phase d'un mécanisme (1) de commande d'aiguille,
comprenant un deuxième dispositif (8) capteur de détermination d'une tension alternative entre le au moins un conducteur (3) de phase et un conducteur (4) neutre du mécanisme (1) de commande d'aiguille, et
comprenant un dispositif (9) d'analyse, qui détermine, à partir des valeurs déterminées de courant et de tension, une puissance active du mécanisme (1) de commande d'aiguille,
**caractérisé en ce que**
le deuxième dispositif (8) capteur est constitué suivant l'une des revendications précédentes.

11. Mécanisme (1) de commande d'aiguille,
comprenant au moins un conducteur (3) de phase pour l'alimentation en courant,
comprenant au moins un conducteur (4) neutre, et
comprenant au moins un dispositif (8) capteur de détermination d'une tension alternative entre le au moins un conducteur (3) de phase et le conducteur (4) neutre,
**caractérisé en ce que**
le dispositif (8) capteur est constitué suivant l'une des revendications 1 à 9 précédentes.

12. Procédé de détermination d'une tension (Ue) alternative entre un conducteur (3) et un potentiel (4) de référence d'un mécanisme de commande d'aiguille,
dans lequel on couple capacitivement un élément (10) de capteur au conducteur (3),
dans lequel on monte un élément (11) de résistance en série avec le potentiel (4) de référence et avec l'élément (10) de capteur, et dans lequel on détermine une chute (Ua) de tension aux bornes de l'élément (11) de résistance,
**caractérisé en ce que**
le dispositif (8) capteur a au moins un élément (18) de blindage, qui est relié à l'élément (11) de résistance et qui est constitué et disposé pour la liaison avec le potentiel (4) de référence, de manière à ce que l'élément (18) de blindage et l'élément (10) de capteur soient couplés entre eux capacitivement.

13. Procédé de diagnostic d'aiguille,
dans lequel on détermine une tension (Ue) alternative entre un conducteur (3) de phase et un conducteur (4) neutre d'un mécanisme (1) de commande d'aiguille et un courant alternatif dans le conducteur (3) de phase,
dans lequel on détermine une puissance active du mécanisme (1) de commande d'aiguille, au moyen de la tension alternative et du courant alternatif, et dans lequel on diagnostique un état du mécanisme de commande d'aiguille, à l'aide de la puissance active, **caractérisé en ce que**
l'on détermine la tension (Ue) alternative par le procédé suivant la revendication 12.
